# EUROPEAN PATENT SPECIFICATION

(11) **EP 0 843 841 B1**
(45) Date of publication and mention of the grant of the patent: **04.09.2002**
(21) Application number: 97920910.3
(22) Date of filing: 27.05.1997
(51) Int. Cl.: G03F 7/42

(54) **STRIPPING COMPOSITION**
ENTSCHICHTUNGSMITTEL
COMPOSITION DE DECAPAGE

(30) Priority: 10.06.1996 EP 96201612
(43) Date of publication of application: 27.05.1998
(73) Proprietor: Koninklijke Philips Electronics N.V., 5621 BA Eindhoven (NL)
(72) Inventor: KUYKEN, Micha[l, Alfred, Josephus, NL-5656 AA Eindhoven (NL); JACOBS, Johannes, Wilhelmus, Maria, NL-5656 AA Eindhoven (NL); SCHELL, Henricus, Wilhelmus, Maria, NL-5656 AA Eindhoven (NL); JANSSEN, Antonius, Theodoor, Jozef, NL-5656 AA Eindhoven (NL)
(74) Representative: Stolk, Steven Adolph
(86) International application number: IB9700599
(87) International publication number: WO97048023

(56) References cited:
- EP-A- 0 219 789
- EP-A- 0 596 515
- EP-A- 0 656 405
- US-A- 4 617 251

## Description

The invention relates to an agent for removing photoresist, which agent comprises a solvent and a primary alcoholamine, said solvent containing an alkyleneglycolalkylether and an organic sulphur-oxide compound. The invention also relates to a method of stripping a photoresist by means of such an agent.

Agents for removing photoresist, also referred to as stripping compositions or strippers for short, are used in lithographic processes in which a substrate is covered with a radiation-sensitive lacquer, also referred to as photoresist or photoresist lacquer, which is subsequently irradiated in accordance with a pattern and developed. After the substrate has been structured, for example, by means of an etchant in accordance with the pattern defined in the photoresist, said photoresist has performed its function and, consequently, should be removed. Photoresist is customarily removed by means of a stripper.

In the electronics industry use is generally made of a so-called positive photoresist on the basis of novolak and a diazonaphtoquinone. If a positive photoresist is used, the stripper should remove photoresist which has not been exposed to radiation.

A photoresist-removing agent of the type mentioned in the opening paragraph is disclosed in European Patent Specification EP-B-267540. The known stripper comprises approximately 50 wt.% N-methylpyrrolidone (NMP), 13 to 24 wt.% tetrahydrothiophene-1,1-dioxide (sulpholane), 9 to 19 wt.% 2-(2-ethoxyethoxy)ethanol, 9 to 19 wt.% polyethyleneglycol and 3 to 10 wt.% of a primary alcoholamine, such as ethanolamine. The stripper can be used to remove positive photoresists, which may have been subjected to a "post-baking" operation, from a substrate. Said Patent Specification further describes a method in which this stripper is used.

The known stripper has drawbacks. For example, it has been found by the inventors that the effectiveness of the known stripper decreases as the number of substrates which are stripped with the same quantity of stripper increase. After a small number of substrates, the effectiveness has decreased to such an extent that the stripper no longer produces satisfactory results. This occurs, in particular, when photoresist has to be removed from extensive substrates having a surface area, for example, of 30 by 40 cm, as are used, for example, in the manufacture of a "liquid-crystal display" (LCD). The decrease in effectiveness of the stripper is undesirable. On the one hand, it leads to a high stripper consumption and a high renewal frequency. The high stripper consumption renders the known stripper unattractive, which can be attributed to either the cost price or the nature of the constituent components, which are not harmless to the environment. The high renewal frequency of the stripper causes the method in which said stripper is employed to be time-consuming from the point of view of logistics and process control. On the other hand, to attain an equal stripping result, the time during which the substrate must be exposed to the stripper has to be increased in the course of time as a result of said decrease in effectiveness, which leads to a time-consuming process control.

It is an object of the invention, inter alia, to eliminate or substantially reduce these disadvantages. The invention particularly aims at providing a photoresist-stripping agent whose effectiveness continues unabated even after the photoresist has been removed from a large number of substrates or, in particular, from a large substrate surface. The effectiveness of the stripper implies that it should take the stripper only a few minutes to strip away all the photoresist to be removed from the substrate. The stripper should even be capable of removing photoresist which has been exposed to a lengthy "post-baking" operation at 150 °C and/or to an etchant, without leaving any residue. If desirable, it should also be possible to employ the stripper at an elevated temperature. The stripper should hardly, if not at all, adversely affect the substrate. In addition, the stripper should not adversely affect the electrical characteristics of any electronic devices present on the substrate. The stripper should further be miscible with water in any ratio, so that, if desirable, rinsing with only water is possible. Moreover, the stripper should be essentially non-toxic. Besides, the effectiveness of the stripper should decrease hardly, or not at all, at a water content up to 30 wt.%. During use of the stripper, such a high water content may occur as rinsing water from a preceding process step is entrained by the substrate and becomes mixed with the stripper.

A further object of the invention is to provide a simple method in which such a stripper is employed.

The object of the invention is achieved by a photoresist-removing agent of the type mentioned in the opening paragraph, which is characterized in accordance with the invention in that the agent essentially comprises 20 to 50 wt. % of the primary alcoholamine and 80 to 50 wt.% of the solvent, said solvent being composed of 30 to 70 wt. % of the alkyleneglycolalkylether and 70 to 30 wt. % of the organic sulphur-oxide compound. The difference in composition between the stripper in accordance with the invention and the known stripper resides particularly in that the stripper in accordance with the invention does not comprise 1-methyl-2-pyrrolidone, but it does comprise a higher content of the primary alcoholamine. As a result, the effectiveness of the stripper in accordance with the invention, specially when it contains water, is higher than that of the known stripper. It has further been found that, in the case of a water content, for example, of 25 wt. %, the increased alcoholamine content does not adversely affect the attack on metals, for example aluminium, present on the substrate. This is surprising, since primary alcoholamines are basic and it is known that an increase in the concentration of a base leads to a substantial increase of the attack on aluminium.

It has been found that the stripper in accordance with the invention essentially retains its effectiveness after a large number of substrates have been treated with it. In a typical experiment, it has been found that the effectiveness of 500 litres of stripper changes hardly, if at all, after it has been used over a period of twelve weeks to strip more than 9000 m² of substrate covered with an 1.3 micrometer thick photoresist layer. Such a result was not achieved with the individual components, i.e. the primary alcoholamine, the organic sulphur-oxide compound and the alkyleneglycolalkylether or binary mixtures thereof. The unabated effectiveness is all the more surprising because the inventors have found that the composition of the stripper is subject to considerable change during the above experiment. For example, as a result of the entrainment of water formed on the substrate by a rinsing step preceding the stripping operation, the stripper contains up to 30 wt.% water after the above-mentioned experiment. The stripper then also contains approximately 0.25 wt. % of stripped photoresist, which leads, specially in the case of strippers to which no alcoholamine is added, to redeposition of the initially dissolved resist. Further, small quantities of degradation products are found in the stripper. However, all these changes hardly, if at all, affect the effectiveness of the stripper.

The stripper is suitable for exposed negative photoresists as well as unexposed positive photoresists. Very good results were achieved with photoresists based on novolak/diazonaphtoquinone, such as PFR3705 (supplier UCB).

Visual inspection by means of a microscope shows that the photoresist is completely removed, even if the photoresist has been subjected to a "post-baking" operation at typically 150 °C, followed by a wet-chemical or dry-chemical etching treatment. This result is already achieved at a temperature of the stripper of 50 °C or less, without the necessity of mechanical auxiliary operations, such as ultrasonic vibration.

The stripping effect can be further improved by employing, if desirable, a higher temperature which, depending on the exact composition, may be, for example, maximally 85 °C. According to international safety standards, the temperature should be chosen to be at least 15 °C below the flash point of the stripper.

The performance of the stripper is substantially independent of the quantity of water introduced during the use of the stripper. The presence of up to 30 wt. % water, as well as up to 0.25 wt. % of dissolved photoresist hardly, if at all, affects the effectiveness of the stripper.

Both in the presence and absence of substantial quantities of water and dissolved photoresist, the substrate is not attacked by the stripper when customary processing times are employed. Particularly in the case of glass, silicon nitride, indium tin oxide and chromium no traces of attack are observed. In a typical experiment, the thickness of a molybdenum layer exposed to the stripper for 5.5 hours decreased by only 6 nm, while, in the presence of 20 wt.% water, this decrease amounted to only 60 nm. Corresponding values for aluminium were 1.5 nm and 15 nm per 5.5 hours.

The stripper comprises 20 to 50 wt. % of a primary alcoholamine. A content below 20 wt. % leads to a reduction of the effectiveness of the stripper in the presence of water, whereas a higher alcoholamine content leads to a less attractive odor as well as to an undesirable increase in cost price and viscosity. On the basis of the same considerations, the stripper preferably comprises 25 to 35 wt. % of the primary alcoholamine.

Suitable primary alcoholamines are primary alcoholamines in accordance with the formula HO-B-A-NH₂, wherein B is A or A-X, A is a branched or unbranched C₁-C₄ alkylene and X is O, NH or CH₂. Alkylene groups higher than C₄ prove to be poorly soluble. Particularly suitable primary alcoholamines are monoethanolamine, 2-(2-aminoethylamino)-ethanol, 2-(2-aminoethoxy)-ethanol, 1-amino-2-propanol and 3-amino-1-propanol. Very suitable primary alcoholamines are 2-(2-aminoethylamino)-ethanol, 2-(2-aminoethoxy)-ethanol, 1-amino-2-propanol and 3-amino-1-propanol. By virtue of its satisfactory stability, preference is given to amine 2-(2-aminoethylamino)-ethanol.

The stripper further contains a solvent which essentially comprises 30 to 70 wt.% of an alkyleneglycolalkylether and 70 to 30 wt.% of an organic sulphur compound. Suitable examples of such ethers are ethyleneglycolmonoalkylethers and propyleneglycolmonoalkylethers. As a result of alleged health hazards attached to the use of ethyleneglycolmonoalkylethers, use is preferably made of propyleneglycolmonoalkylethers. Suitable propyleneglycolmonoalkylethers are propyleneglycolmonomethylether, propyleneglycolmonoethylether, dipropyleneglycolmonomethylether, dipropyleneglycolmonoethylether, tripropyleneglycolmonomethylether and tripropyleneglycolmonoethylether. An ether which is very suitable is dipropyleneglycolmonomethylether.

Suitable organic sulphur-oxide compounds are dimethylsulphoxide and sulpholanes. Suitable sulpholanes are sulpholane, 3-methylsulpholane, 3,4-dimethylsulpholane, 2,5-dimethylsulpholane, 3-methoxysulpholane, 2,4-dimethyl-3-methoxysulpholane, 2,4-dimethyl-4-ethoxysulpholane, 3,4-diethoxysulpholane, 2-methoxy-3-ethylsulpholane, 3,3-dimethylsulpholane, 2,2-diethylsulpholane. Particularly suitable is dimethylsulphoxide (DMSO).

The melting point of DMSO is 18.5 °C and the melting point of sulpholane is 27.5 °C. Although the stripper will be generally employed at temperatures which are higher than said melting points, it will usually be stored at a temperature which is lower than said melting points, so that strippers which only contain these compounds as a solvent will crystallize, which is unacceptable, particularly, in view of the quantities to be stored, typically hundreds of litres. This disadvantage is obviated by adding alkyleneglycolalkylether.

The weight percentages of the stripping composition in accordance with the invention relate to strippers in the unused state. As mentioned hereinabove, the composition of the stripper changes during use as a result of, for example, the entrainment of water and the absorption of photoresist. The presence of considerable quantities of other components and/or the use of other weight percentages adversely affect the solubility and/or the effectiveness of the stripper in the presence of water, thereby limiting the number of substrates which can be stripped with the same quantity of stripper.

A particularly suitable agent for removing photoresist is characterized in accordance with the invention in that 2-(2-aminoethylamino)-ethanol is chosen as the primary alcoholamine, dipropyleneglycolmonomethylether is chosen as the alkyleneglycolalkylether, and dimethyl sulphoxide is chosen as the organic sulphur-oxide compound.

The invention also relates to a method of the type mentioned in the opening paragraph, which is characterized in accordance with the invention in that an agent in accordance with any one of the preceding claims is used.

Using the stripper in accordance with the invention has the advantage that a method of removing photoresist is obtained which is attractive from the point of view of the environment, process control and logistics. The method has a low renewal frequency, a low stripper consumption and enables more than 9000 m² of substrate surface to be stripped with only 500 1 of the stripping composition. By virtue thereof, the method is less labor-intensive and leads to a reduction in downtime of the equipment, so that a substantial saving in costs is achieved.

The stripper can be brought into contact with the substrate in a customary manner. Suitable methods are, for example, immersion in a bath containing a stripper, and a "puddle" or "spray" process.

Customarily, the substrate is dried, prior to stripping to remove the water used to rinse off the etchant. As the stripping composition preserves its effectiveness despite the presence of a substantial quantity of water, this drying step may be dispensed with, which leads to a simplification of the method.

These and other aspects of the invention will be apparent from and elucidated with reference to the examples described hereinafter.

### Example 1

A layer of a positive photoresist (type PFR3705, supplier UCB) based on novolak and diazonaphtoquinone is spin coated onto a glass substrate, having dimensions of 30 by 40 cm, on which a 10 nm thick chromium layer is situated. To simulate the typical conditions to which a photoresist is exposed, the photoresist is post-baked at 135 °C for 5 minutes, then subjected to a wet etching treatment with cerium(IV) nitrate acidified with nitric acid for 1000 s and subsequently post-baked at 140 °C for half an hour. In a first experimental example (Exp. 1), a substrate thus prepared is immersed in a bath comprising the stripping composition for 1 minute at 50 °C. To test the effectiveness of the stripper after a large number of substrates have been cleaned, a second experiment (Exp. 2) is carried out in which an equal substrate is immersed in a bath comprising the same stripper to which 30 wt. % water and 0.25 wt.% photoresist are added. Further examples are obtained by repeating these experiments with a number of different stripping compositions. The stripping compositions used and the results of the stripping operations are shown in Table I.

**Table I**

| Example No. | Composition | | | Result of stripping operation | |
|---|---|---|---|---|---|
| | DMSO | DPM | AEAE | Exp. 1 | Exp. 2 |
| 1 | 35 | 35 | 30 | 10 | 10 |
| 2 | 40 | 34.5 | 25.5 | 10 | 10 |
| 3 | - | 90 | 10 | 6 | 8 |
| 4 | 45 | 45 | 10 | 10 | 8 |
| 5 | 50 | 50 | - | 4 | 3 |
| 6 | 90 | - | 10 | 10 | 7 |

Examples 1 and 2 relate to strippers in accordance with the invention, the other examples are comparative examples.

The abbreviation DMSO means dimethylsulphoxide, DPM means dipropyleneglycolmonomethylether and AEAE means 2-(2-aminoethylamino)ethanol.

The composition is indicated in percentages by weight and relates to the individual components. Thus, the stripper in the first example comprises 70 wt. % solvent, which solvent contains 50 wt. % DPM.

The result of the stripping operation is indicated by a rating on a scale from 1 to 10, with 10 corresponding to a perfect stripping result, i.e. visual inspection under a microscope (40 x) does not reveal photoresist residues. The lower the rating, the larger the quantity of photoresist residue observed on the substrate. The data listed in the Table show that the best and most consistent stripping result as a function of the quantity of amine, water and photoresist is obtained by means of the composition DMSO/DPM/AEAE. Thus, it has been established that the effectiveness of the stripper in accordance with the invention continues unabated after the photoresist has been removed from a large number of substrates.

Comparable results are achieved with stripping compositions in which AEAE is replaced by 2-(2-aminoethoxy)ethanol or 3-amino-1-propanol.

### Example 2

A glass substrate, having dimensions of 320 mm by 400 mm, carrying metal tracks of indium tin oxide, chromium, aluminium, molybdenum, as well as oxides derived therefrom, which together form a panel of a "liquid-crystal display", is provided with a positive photoresist (type PFR3705, supplier UCB) by spin coating, whereafter said positive photoresist is post-baked at 135 °C for 5 minutes. The layer thickness of the photoresist is 1.3 micrometer. By repeating these process steps, a batch comprising 24 substrates is formed. These substrates are subsequently etched with cerium(IV) nitrate acidified with nitric acid for 1000 s and rinsed with water. Subsequently, the batch is immersed in a first stripping bath for 3 minutes and, subsequently, in a second stripping bath for 3 minutes. Each bath is filled with 250 litres of a stripper in accordance with the invention, which comprises 40 wt.% DMSO (Merck), 34.5 wt.% DPM (Dow Chemical Co.) and 25.5 wt.% AEAE (Merck) which is maintained at a temperature of 60 °C. Over a period of twelve weeks, 3000 such batches are stripped, without renewing the contents of the baths. During this period of time, the water content of the stripper in the first bath increases to 20 wt. %, and the photoresist content increases to 0.25 wt.%. In the second bath, comparable quantities are observed. Random visual inspection by means of a microscope (40 x) reveals that the substrates thus stripped are free of photoresist residues. Corrosion of the metals and metal oxides present on the substrate is substantially absent, which is established by determining the concentration of aluminium, chromium and molybdenum in the bath. A comparison of the current/voltage characteristics between the test structures of the first and the last batches present on the substrate also reveals that corrosion is substantially absent. After said period of twelve weeks, the effectiveness of the stripper continues unabated.

### Example 3

Example 1 is repeated, with this difference that the substrate is exposed to the stripper for only 10 seconds at a temperature of 25 °C. The stripping results for different stripping compositions are shown in Table II.

**Table II**

| Example No. | Composition | | | Result of stripping operation | |
|---|---|---|---|---|---|
| | DMSO | DPM | AEAE | Exp. 1 | Exp. 2 |
| 1 | 35 | 35 | 30 | 10 | 10 |
| 2 | 40 | 34.5 | 25.5 | 10 | 10 |
| 3 | - | 90 | 10 | 0 | 0,5 |
| 4 | 45 | 45 | 10 | 9 | 9 |
| 5 | 50 | 50 | - | 5 | 2 |
| 6 | 90 | - | 10 | 10 | 9 |
| 7 | 70 | - | 30 | 10 | 9 |
| 8 | - | 70 | 30 | 0 | 1 |
| 9 | - | - | 10 | 10 | 9 |

Examples 1 and 2 relate to strippers in accordance with the invention, the other examples are comparative examples. The stripper of example 9 is disclosed in European Patent Specification EP-B-267540 and comprises 50 wt. % NMP, 13 wt.% sulpholane, 9 wt.% 2-(2-ethoxyethoxy)ethanol, 18 wt.% polyethyleneglycol and 10 wt.% AEAE. The composition is indicated in percentages by weight and relates to the individual components. The stripping result is rated in the same manner as in example 1. The data listed in the Table reveal that the best and most consistent stripping result as a function of the quantity of amine, water and photoresist is attained by means of the composition DMSO/DPM/AEAE. Thus, it is established that the effectiveness of the stripper in accordance with the invention continues unabated after photoresist has been removed from a large number of substrates.

## Claims

1. An agent for removing photoresist, which agent comprises a solvent and a primary alcoholamine, said solvent containing an alkyleneglycolalkylether and an organic sulphur-oxide compound, **characterized in that** the agent essentially comprises 20 to 50 wt.% of the primary alcoholamine and 80 to 50 wt. % of the solvent, said solvent being composed of 30 to 70 wt. % of the alkyleneglycolalkylether and 70 to 30 wt. % of the organic sulphur-oxide compound.

2. An agent for removing photoresist as claimed in Claim 1, **characterized in that** 2-(2-aminoethylamino)-ethanol is chosen as the primary alcoholamine, dipropyleneglycolmonomethylether is chosen as the alkyleneglycolalkylether, and dimethylsulphoxide is chosen as the organic sulphur-oxide compound.

3. A method of stripping a photoresist from a substrate, in which the photoresist is brought into contact with an agent for removing photoresist, **characterized in that** an agent as claimed in any one of the preceding Claims is used.

4. A method as claimed in Claim 3, **characterized in that** a panel for a "liquid-crystal display" or a silicon wafer is used as the substrate.

## Patentansprüche

1. Mittel zum Entfernen von Photoresist, wobei dieses Mittel ein Lösungsmittel und ein primäres Alkoholamin enthält, wobei das genannte Lösungsmittel einen Alkylenglykolalkylether und eine organische Schwefeloxidmasse enthält, **dadurch gekennzeichnet, dass** das Mittel im Wesentlichen 20 bis 50 Gewichtsprozent des primären Alkoholamins und 80 bis 50 Gewichtsprozent des Lösungsmittels enthält, wobei das genannte Lösungsmittel aus 30 bis 70 Gewichtsprozent des Alkylenglycolalkylethers und 70 bis 30 Gewichtsprozent der organischen Schwefeloxidmasse zusammengesetzt ist.

2. Mittel zum Entfernen von Photoresist nach Anspruch 1, **dadurch gekennzeichnet, dass** 2-(2-Aminoethylamino)-ethanol gewählt wird als primäres Alkoholamin, dass Dipropylenglycolmonomethylether als Alkylenglycolalkylether gewählt wird, und dass Dimethylschwefeloxid als die organische Schwefeloxidverbindung gewählt wird.

3. Verfahren zum Entschichten eines Photoresists von einem Substrat, wobei der Photoresist mit einem Mittel zum Entfernen von Photoresist in Berührung gebracht wird, **dadurch gekennzeichnet, dass** ein Mittel nach einem der vorstehenden Ansprüche benutzt wird.

4. Verfahren nach Anspruch 3, **dadurch gekennzeichnet, dass** eine Platte für eine LCD oder eine Siliziumscheibe als Substrat benutzt wird.

## Revendications

1. Agent pour enlever du photorésist, ledit agent comprenant un solvant et une amine d'alcool primaire, ledit solvant contenant un composé d'alcoylèneglycolalcoyléther et un composé d'oxyde de soufre organique, **caractérisé en ce que** l'agent comprend essentiellement 20 à 50% en poids de l'amine d'alcool primaire et 80 à 50% en poids du solvant, ledit solvant étant composé de 30 à 70% en poids du composé de l'alcoylèneglycolalcoyléther et 70 à 30% en poids du composé d'oxyde de soufre organique.

2. Agent pour enlever du photorésist selon la revendication 1, **caractérisé en ce que** du 2-(2-aminoéthylamino)-éthanol est choisi comme amine d'alcool primaire, du dipropylèneglycolmonométhyléther est choisi comme alcoylèneglycolalcoyléther et du diméthylesulfoxyde est choisi comme composé d'oxyde de soufre organique.

3. Procédé pour enlever un photorésist d'un substrat par décapage, où le photorésist est mis en contact avec un agent pour enlever du photorésist, **caractérisé en ce que** l'on utilise un agent selon l'une quelconque des revendications précédentes.

4. Procédé selon la revendication 3, **caractérisé en ce qu'**un panneau pour un "dispositif d'affichage à cristaux liquides" ou une tranche en silicium est utilisée comme substrat.
